# EUROPÄISCHE PATENTSCHRIFT

(11) **EP 1 584 136 B1**
(45) Veröffentlichungstag und Bekanntmachung des Hinweises auf die Patenterteilung: **10.10.2007**
(21) Anmeldenummer: 03797959.8
(22) Anmeldetag: 06.08.2003
(51) Int. Cl.: H03F 1/32

(54) **Schaltungsanordnung für Rückkopplung vom Sender zum Empfänger in einem Multimode-Mobiltelefon mit Vorverzerrung**
Circuit arrangement for a predistorted feedback coupling from a transmitter to a receiver in a multi-mode mobile telephone
Ensemble circuit pour rétroaction de l'émetteur vers le récepteur dans un téléphone mobile multimode à prédistorsion

(30) Priorität: 16.01.2003 DE 10301499
(43) Veröffentlichungstag der Anmeldung: 12.10.2005
(73) Patentinhaber: SIEMENS AKTIENGESELLSCHAFT, 80333 München (DE)
(72) Erfinder: VOLLMER, Jürgen, 46397 Bocholt (DE); IRSCHEID, Otmar, Hawalli 32060 (KW); LANGER, Andreas, 85716 Unterschleissheim-Lohhof (DE)
(86) Internationale Anmeldenummer: PCT/DE2003/002642
(87) Internationale Veröffentlichungsnummer: WO 2004/070942

(56) Entgegenhaltungen:
- EP-A- 0 715 420
- EP-A- 0 928 072
- EP-A- 1 014 591
- EP-A- 1 067 676
- EP-A- 1 217 757
- WO-A-01/99298
- PATENT ABSTRACTS OF JAPAN vol. 1996, no. 12, 26. Dezember 1996 (1996-12-26) -& JP 08 204605 A (HITACHI DENSHI LTD), 9. August 1996 (1996-08-09)

## Beschreibung

In vielen Bereichen, wie beispielsweise auch bei Multimode-Mobiltelefon, wird eine lineare Signalverstärkung mit hoher Leistungseffizienz benötigt. Eine Möglichkeit eine lineare Signalverstärkung zu erreichen besteht darin, einen nichtlinearen Leistungsverstärker (= PA = Power Amplifier), der also eine nichtlineare Kennlinie aufweist, ein System, den Vorverzerrer, vorzuschalten. Der Vorverzerrer verzerrt die Eingangssignale so, dass das Gesamtsystem aus Vorverzerrer und nicht linearer Leistungsverstärker wieder ein wesentlich lineareres Verhalten als nur ein Leistungsverstärker aufweist. Dieses Verstärkungsverfahren wird Predistortion ("Vorverzerrung") genannt. Durch die Kombination der Vorverzerrerkennlinie des eingespeisten Signals und der nichtlinearen Verstärkerkennlinie ergibt sich insgesamt eine lineare Kennlinie des Sendesystems und somit eine lineare Signalverstärkung. Ein Problem bei dieser Verstärkungsmethode tritt durch die Alterung von Bauteilen oder die Temperaturabhängigkeit der Bauteile auf. Durch diese Effekte ändert sich wiederum die Linearität.

Um diese unerwünschten Effekte zu korrigieren, wird bei der digitalen adaptiven Predistortion die Einhüllende des verstärkten Signals mit Hilfe eines Messzweigs, dem Rückkopplungszweig, zurückgewonnen. Danach wird eine Adaption der Kennlinie des Vorverzerrers vorgenommen. Dieser Rückkopplungszweig besteht meistens aus einem Koppler, einem Demodulator und einem Analog-Digital-Converter (Abkürzung: ADC).

Ein Nachteil bei dieser Methode der digitalen adaptiven Predistortion ist, dass der Rückkopplungszweig einen zusätzlichen Aufwand an Kosten, Bauraum und Energieverbrauch verursacht. Aus diesem Grund werden bisher in kommerziellen Systemen keine Linearisierungsmethoden für Leistungsverstärker realisiert, die einen komplexen Rückkopplungszweig benötigen.

Es ist daher Aufgabe der Erfindung, eine Schaltungsanordnung für ein Multimode-Mobiltelefon vorzustellen, die eine digitale adaptive Predistortion ermöglicht, ohne zusätzliche Hardwarekomponenten für den Rückkopplungszweig einzusetzen.

Diese Aufgabe wird durch die Merkmale des unabhängigen Patentanspruches 1 gelöst. Vorteilhafte Weiterbildungen der Erfindung sind Gegenstand untergeordneter Patentansprüche.

Zwar ist aus der japanischen Patentanmeldung JP 08 204605 A eine Schaltungsanordnung für ein Walkie-Talkie bekannt mit einem Rückkopplungszweig zur digitalen adaptiven Predistortion. Hinweise auf ein Multimode-Mobiltelefon mit einem ersten und einem zweiten Empfänger sowie mindestens einem Senderverstärker, wobei der Senderverstärker und der zweite Empfänger für unterschiedliche Modes des Multimode-Mobiltelefons ausgelegt sind, und wobei der zweite Empfänger zur Verwendung als Rückkopplungszweig im Rahmen einer digitalen adaptiven Predistortion ausgebildet ist, liefert die bekannte Druckschrift jedoch nicht.

Die Erfinder haben erkannt, dass zum einen bestehende Hardwarekomponenten einer bekannten Schaltungsanordnung für ein Multimode-Mobiltelefon nicht permanent für ihre vorgesehenen Aufgaben genutzt werden. Zum anderen sind diese bestehende Hardwarekomponenten auch dafür geeignet, im Rahmen der digitalen adaptiven Predistortion, als Rückkopplungszweig zu fungieren.

Entsprechend dem allgemeinen Erfindungsgedanken schlagen die Erfinder vor, eine bestehende Schaltungsanordnung für ein Multimode-Mobiltelefon zum Senden/Empfangen von Signalen in/aus verschiedene/n Mobilfunknetze/n mit: einem Basisband, in dem zumindest zwei Analog-Digital-Converter und ein Digital-Analog-Converter angeordnet sind, und einer Sende- und Empfangseinheit, in der mindestens ein erster Empfänger und ein zweiter Empfänger und mindestens ein Senderverstärker angeordnet sind, wobei sowohl Verbindungen zwischen den Ausgängen der Empfänger und den Analog-Digital-Convertern, und eine Verbindung zwischen dem Eingang des Senderverstärkers und dem Digital-Analog-Converter bestehen, als auch Verbindungen zwischen den Eingängen des ersten, des zweiten Empfängers, dem Ausgang des Senderverstärker und einem Antennenschalter bestehen, wobei der Antennenschalter an eine Sende- und Empfangsantenne angeschlossen ist, und außerdem Mittel zum Durchführen einer digitale adaptive Predistortion vorgesehen sind, dahingehend zu verbessern, dass mindestens ein Schaltelement derart zwischen dem Ausgang des mindestens einen Senderverstärkers und dem Eingang des zweiten Empfängers angeordnet ist, das wahlweise eine Verbindung geschaffen wird, die den Ausgang des mindestens einen Senderverstärkers mit dem Eingang des zweiten Empfängers verbindet und gleichzeitig die Verbindung des Eingangs dieses zweiten Empfängers zum Antennenschalter trennt.

Hierdurch ist es möglich, dass in den Zeiten, in denen der zweite Empfänger keine Signale von der Sende- und Empfangsantenne übermittelt bekommt, von dieser abgetrennt werden kann und dafür andere Signale empfangen kann. So können beispielsweise mit einem einfachen Schalter, der in einer Schalterposition die Verbindung des zweiten Empfängers zur Sende- und Empfangsantenne trennt und gleichzeitig eine Verbindung zwischen dem Ausgang des Senderverstärkers und Eingang des zweiten Empfängers herstellt, die Signale am Ausgang des Senderverstärkers abgegriffen werden und mit dem zweiten Empfänger detektiert werden.

Es ist besonders günstig, wenn das mindestens eine Schaltelement im Antennenschalter angeordnet ist. So findet im Antennenschalter eine Trennung der gesendeten und empfangenen Signale hinsichtlich der Frequenz und der Zeit statt. Für diese Aufgaben sind im Antennenschalter gewisse Schaltfunktionen integriert. Durch zusätzliche Integration des Schaltelementes im Antennenschalter wird eine besonders günstige Variante für die Schaltvorrichtung vorgestellt.

Es ist vorteilhaft, wenn der mindestens eine erste Empfänger Signale aus dem UMTS-Netz übermittelt bekommt und der mindestens eine zweite Empfänger Signale aus dem GSM-Netz übermittelt bekommt. So kann der erste Empfänger immer für den Empfang aus dem UMTS-Netz zur Verfügung stehen, während der zweite Empfänger, der das GSM-Netz nur zeitweise monitort, in der Zeit in der keine Signale aus dem GSM-Netz empfangen werden, die Signalmessung am Senderverstärkerausgang vornimmt. Der zweite Empfänger sollte also die Anforderungen für eine UMTS-Predistortion als auch für GSM-Empfang erfüllen, das heißt dieser Empfänger sollte rekonfigurierbar sein. Hierdurch werden die bestehenden Hardwarekomponenten, die in gewissen Zeiten nicht verwendet werden, effektiver genutzt und in der Schaltungsanordnung müssen keine zusätzlichen Hardwarekomponenten ,die Zusatzkosten und Bauraum bedeuten, eingebaut werden.

Zusätzliche Merkmale und Vorteile der Erfindung ergeben sich aus der nachfolgenden Beschreibung bevorzugter Ausführungsbeispiele unter Bezugnahme auf die Zeichnungen.

Die Erfindung soll nachfolgend anhand der Zeichnungen näher erläutert werden.
- Figur 1:: Bekannte Schaltungsanordnung für Multimode-Mobiltelefone, in der mit Hilfe von einem Rückkopplungszweig eine digitale adaptive Predistortion durchgeführt wird;
- Figur 2:: Schaltungsanordnung für Multimode-Mobiltelefone, in der mit einem von zwei Empfängern eine digitale adaptive Predistortion durchgeführt wird.

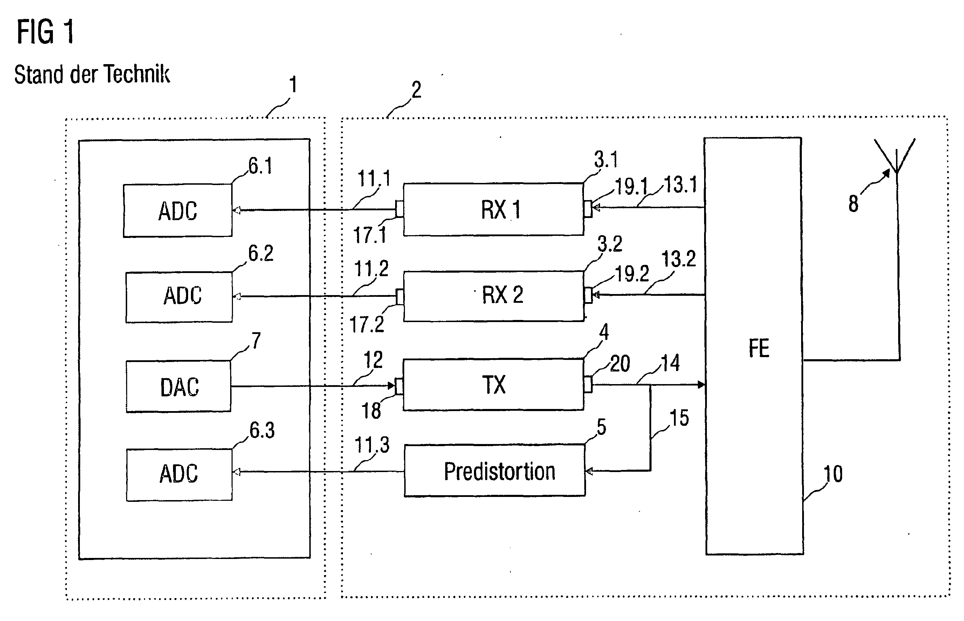

Die Figur 1 zeigt eine bekannte Schaltungsanordnung für Multimode-Mobiltelefone, in der mit Hilfe von einem Rückkopplungszweig 5 eine digitale adaptive Predistortion durchgeführt wird. Diese Schaltungsanordnung besteht im wesentlichen aus einer Sende- und Empfangseinheit 2 und einer mit Basisband 1 bezeichneten Einheit, in der die für das Verfahren der digitalen adaptiven Predistortion notwendige Signalvorverzerrung stattfindet.

Die Sende- und Empfangseinheit 2, die in Figur 1 durch einen gepunkteten Kasten eingerahmt ist, besteht ihrerseits aus einer Sende- und Empfangsantenne 8, die über einen Antennenschalter 10 Verbindungen 13.1, 13.2 und 14 jeweils mit den Eingängen 19.1 und 19.2 der beiden Empfängern (RX 1 und RX 2) 3.1 und 3.2 und mit dem Ausgang 20 des Senderverstärkers(TX) 4 aufweist. In dieser Ausführung ist der Empfänger 3.1 (RX 1) und der Senderverstärker 4 (TX) für den Signalempfang/die Signalübertragung aus/in dem/das UMTS-Netz geeignet. Es handelt sich um den bekannten FDD-UMTS Standard (= Frequency Division Duplex-Universal Mobile Telecommunikations System), bei dem mehrere Frequenzbänder genutzt werden. Durch die mehreren Frequenzbänder ist hier ein gleichzeitiges Senden und Empfangen von Signalen auf den verschiedenen Frequenzbändern möglich, wobei die Signale hinsichtlich der Amplitude und der Phase moduliert sein können. Mit dem Empfänger 3.2 (RX 2) wird das GSM-Netz (GSM = Global System Mobile) gemonitort. Im GSM-Netz werden die Signale phasenmoduliert im Zeitmultiplexverfahren, in sogenannten Zeitschlitzen oder mit Timeslots bezeichnet, übertragen. Im GSM-Netz ist kein gleichzeitiges Senden und Empfangen von Signalen möglich. Mit dem Antennenschalter 10 können die über die Sende- und Empfangsantenne 8 gesendeten und die empfangenen Signale hinsichtlich der Frequenz und der Zeit getrennt werden.

Links in Figur 1, durch einen gepunkteten Kasten eingerahmt, ist das Basisband 1 dargestellt. Das Basisband 1 verfügt über insgesamt drei Analog-Digital-Converter 6.1 bis 6.3 und einen Digital-Analog-Converter 7. Die beiden oberen Analog-Digital-Converter 6.1 und 6.2 bekommen jeweils über die Verbindungen 11.1 und 11.2 analoge Signale von den Ausgängen 17.1 und 17.2 der ersten und zweiten Empfänger (RX 1 und RX 2) 3.1 und 3.2 übermittelt. Um mit dieser Schaltungsanordnung das Verfahren der digitalen adaptiven Predistortion durchführen zu können, ist der unterste Digital-Analog-Converter 7 im Basisband 1 vorgesehen, der über die Verbindung 12 zum Eingang 18 des Senderverstärker 4 (TX) vorverzerrte Signale übermittelt.

Um mit dieser Schaltungsanordnung eine lineare Signalverstärkung zu erhalten, muss das über die Verbindung 12 am Eingang 18 des Senderverstärkers (TX) 4 eingespeiste und vorverzerrte Signal am Ausgang 20 des Senderverstärkers (TX) 4 abgegriffen und mit dem eingespeisten Signal verglichen werden.

Hierzu ist am Ausgang 20 des Senderverstärkers (TX) 4 eine Abzweigung 15 für einen Messzweig vorgesehen. Dieser Messzweig auch Rückkopplungszweig 5 genannt, nutzt außerdem den untersten Analog-Digital-Converter 6.3. Über den Vergleich des am Eingang 18 eingespeisten Signals mit dem am Ausgang 20 ausgegeben Signal können Nichtlinearitäten der Signalverstärkung detektiert und korrigiert werden.

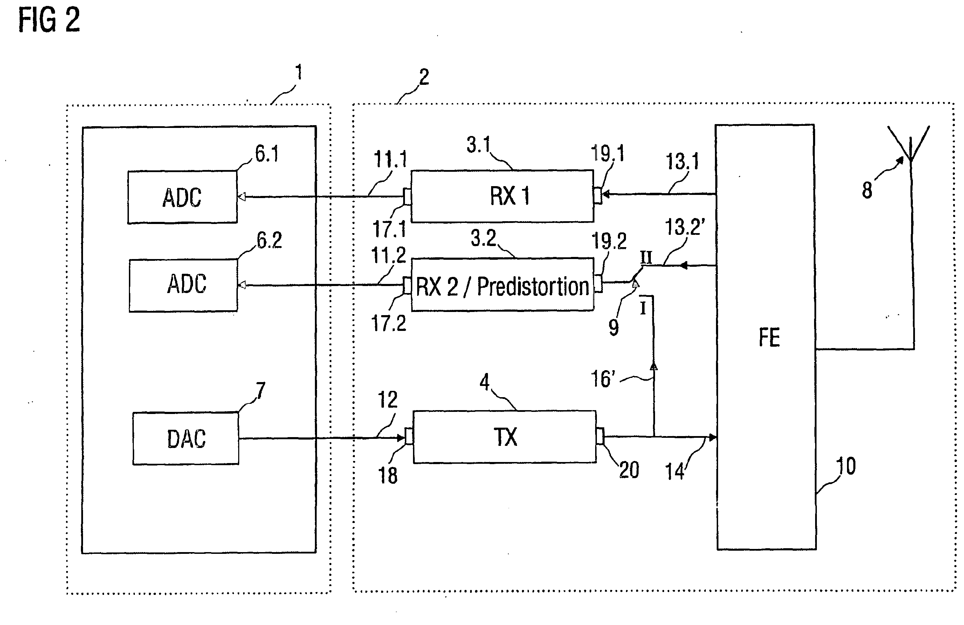

Die Figur 2 zeigt eine neue Schaltungsanordnung für Multimode-Mobiltelefone, in der, mit einem Empfänger (RX 2) 3.2 von zwei Empfängern (RX 1 und RX 2) 3.1 und 3.2, eine digitale adaptive Predistortion durchgeführt werden kann. Analog zu Figur 1 besteht diese Schaltungsanordnung im wesentlichen aus einer Sende- und Empfangseinheit 2 und einer mit Basisband 1 bezeichneten Einheit.

Die Sende- und Empfangseinheit 2 besteht analog zu Figur 1 aus einer Sende- und Empfangsantenne 8, die über einen Antennenschalter 10 Verbindungen 13.1, 13.2 und 14 jeweils mit den beiden Eingängen 19.1 und 19.2 der Empfänger (RX 1 und RX 2) 3.1 und 3.2 und dem Ausgang 20 des Senderverstärker (TX) 4 aufweist. In dieser Ausführung ist der Empfänger 3.1 (RX 1) und der Senderverstärker 4 (TX) für den Signalempfang und die Signalübertragung in das UMTS-Netz geeignet. Es handelt sich um den bekannten FDD-UMTS Standard (= Frequency Division Duplex-Universal Mobile Telecommunications System), bei dem mehrere Frequenzbändern genutzt werden. Durch die mehreren Frequenzbänder ist hier ein gleichzeitiges Senden und Empfangen von Signalen auf den verschiedenen Frequenzbändern möglich, wobei die Signale hinsichtlich der Amplitude und der Phase moduliert sein können. Mit dem zweiten Empfänger 3.2 (RX 2) wird das GSM-Netz (GSM = Global System Mobile) gemonitort. Im GSM-Netz werden die Signale phasenmoduliert im Zeitmultiplexverfahren, in sogenannten Zeitschlitzen oder mit Timeslots bezeichnet, übertragen. Im GSM-Netz ist kein gleichzeitiges Senden und Empfangen von Signalen möglich. Mit dem Antennenschalter 10 können die über die Sende- und Empfangsantenne 8 gesendeten und die empfangenen Signale hinsichtlich der Frequenz und der Zeit getrennt werden.

Im Unterschied zu Figur 1 ist in der neuen Schaltungsanordnung, kein eigener Rückkopplungszweig 5 am Ausgang des Senderverstärkers (TX) 4, zur Überwachung des Signals am Ausgang 20 des Senderverstärkers (TX) 4, vorgesehen. Durch den fehlenden Rückkopplungszweig 5 kann gleichzeitig der bisher notwendige Analog-Digital-Converter 6.3 (unterster ADC aus Figur 1) im Basisband 1 eingespart werden.

Um mit der neuen Schaltungsanordnung dennoch das Signal am Ausgang 20 des Senderverstärkers (TX) 4 detektieren zu können ist ein Schalter 9 angebracht. Ist der Schalter 9 in der Schalterstellung II so ist der Eingang 19.2 des Empfänger (RX 2) 3.2 über die wahlweise Verbindung 13.2' mit den Antennenschalter 10 und mit der Sende- und Empfangsantenne 8 verbunden. In Schalterstellung II kann also das GSM-Netz gemonitort werden. Wie oben beschrieben, werden im GSM-Netz die Signale phasenmoduliert im Zeitmultiplexverfahren, in sogenannten Zeitschlitzen oder mit Timeslots bezeichnet, übertragen.

Es besteht also nun die Möglichkeit, in diesen Zeitschlitzen, in denen keine GSM-Signale an den Eingang 19.2 des Empfängers (RX 2) 3.2 übermittelt werden, diesen Empfänger (RX 2) 3.2 zur Überwachung der Signale, die am Ausgang 20 des Senderverstärkers (TX) 4 ausgegeben werden, zu nutzen.. Hierzu wird der Schalter 9 in diesen Zeitschlitzen auf die Schalterstellung I bewegt, und somit die wahlweise Verbindung 13.2' des zweiten Empfängers (RX 2) 3.2 und dem Antennenschalter 10 getrennt und gleichzeitig die wahlweise Verbindung 16' vom Ausgang 20 des Senderverstärkers (TX) 4 zum Eingang 19.2 des zweiten Empfängers (RX 2) 3.2 hergestellt. Der zweite Empfängers (RX 2) 3.2 und der Analog-Digital-Converter 6.2 fungieren nun als Rückkopplungszweig.

Insgesamt wird also durch die Erfindung, eine Schaltungsanordnung für ein Multimode-Mobiltelefon vorgestellt, die es ermöglicht, eine digitale adaptive Predistortion durchzuführen. Bei dieser Schaltungsanordnung wird zur Messung des verstärkten Signals nicht wie bisher ein zusätzlicher Messzweig benötigt, sondern es werden bestehende Hardwarekomponenten der Schaltungsanordnung derart geschaltet, dass diese die selbe Funktion wie der Messzweig haben. Je nach Schaltstellung des Schaltelementes eignet sich der zweite Empfänger zur Durchführung zum Beispiel einer UMTS-Predistortion als auch für den GSM-Empfang.

Es versteht sich, das die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

### Bezugszeichenliste

- 1: Basisband
- 2: Sende- und Empfangseinheit
- 3.1: erster Empfänger RX 1
- 3.2: zweiter Empfänger RX 2
- 4: Senderverstärker TX
- 5: Rückkopplungszweig
- 6.1: Analog-Digital-Converter (ADC) des ersten Empfängers RX 1
- 6.2: Analog-Digital-Converter (ADC) des zweiten Empfängers RX 2
- 6.3: Analog-Digital-Converter (ADC) des Rückkopplungszweigs
- 7: Digital-Analog-Converter (DAC) des Senderverstärkers TX
- 8: Sende- und Empfangsantenne
- 9: Schalter mit zwei Schalterstellungen I und II
- 10: Antennenschalter/Front End (FE)
- 11.1: Verbindung des Ausgangs des ersten Empfängers RX 1 mit dem Analog-Digital-Converter 6.1
- 11.2: Verbindung des Ausgangs des zweiten Empfängers RX 2 mit dem Analog-Digital-Converter 6.2
- 11.3: Verbindung des Rückkopplungszweigs mit dem Analog-Digital-Converter 6.3
- 12: Verbindung des Digital-Analog-Converter mit dem Eingang des Senderverstärker TX
- 13.1: Verbindung des Antennenschalters mit dem Eingang des ersten Empfängers RX 1
- 13.2: Verbindung des Antennenschalters mit dem Eingang des zweiten Empfängers RX 2
- 13.2': wahlweise Verbindung des Antennenschalters mit dem Eingang des zweiten Empfängers RX 2
- 14: Verbindung des Ausgangs des Senderverstärkers TX mit dem Antennenschalter
- 15: Abzweigung des Ausgangs des Senderverstärkers TX zum Rückkopplungszweig
- 16': wahlweise Verbindung des Ausgang des Senderverstärkers TX mit dem Eingang des zweiten Empfängers RX 2
- 17.1: Ausgang des ersten Empfängers RX 1
- 17.2: Ausgang des zweiten Empfängers RX 2
- 18: Eingang des Senderverstärkers TX
- 19.1: Eingang des ersten Empfängers RX 1
- 19.2: Eingang des zweiten Empfängers RX 2
- 20: Ausgang des Senderverstärkers TX

## Patentansprüche

1. Schaltungsanordnung für ein Multimode-Mobiltelefon zum Senden/Empfangen von Signalen in/aus verschiedene/n Mobilfunknetze/n mit:
- einem Basisband (1), in dem zumindest zwei Analog-Digital-Converter (6.1 bis 6.3) und ein Digital-Analog-Converter (7) angeordnet sind, und
- einer Sende- und Empfangseinheit (2), in der mindestens ein erster Empfänger (3.1) und ein zweiter Empfänger (3.2) und mindestens ein Senderverstärker (4) angeordnet sind, wobei der Senderverstärker (4) und der zweite Empfänger (3.2) für unterschiedliche Modes des Multimode-Mobiltelefons ausgelegt sind, wobei sowohl Verbindungen (11.1, 11.2) zwischen den Ausgängen (17.1, 17.2) der Empfänger (3.1, 3.2) und den Analog-Digital-Convertern (6.1, 6.2) und eine Verbindung (12) zwischen dem Eingang (18) des Senderverstärkers (4) und dem Digital-Analog-Converter (7) bestehen, als auch Verbindungen (13.1, 13.2, 13.2' und 14) zwischen den Eingängen (19.1, 19.2) des ersten, des zweiten Empfängers (3.1, 3.2), dem Ausgang (20) des Senderverstärkers (4) und einem Antennenschalter (10) bestehen, wobei der Antennenschalter (10) an eine Sende- und Empfangsantenne (8) angeschlossen ist, und wobei der zweite Empfänger (3.2) zur Verwendung als Rückkopplungszweig im Rahmen einer digitalen adaptiven Predistortion ausgebildet ist, und mindestens ein Schaltelement (9) derart zwischen dem Ausgang (20) des mindestens einen Senderverstärker (4) und dem Eingang (19.2) des zweiten Empfängers (3.2) angeordnet ist, das wahlweise entweder eine Verbindung (16') geschaffen wird, die den Ausgang (20) des mindestens einen Senderverstärkers (4) mit dem Eingang (19.2) des zweiten Empfängers (3.2) verbindet oder eine Verbindung geschaffen wird, die den Eingang (19.2) dieses zweiten Empfängers (3.2) mit dem Antennenschalter (10) verbindet.

2. Schaltungsanordnung gemäß dem voranstehenden Patenanspruch 1,
**dadurch gekennzeichnet,**
**dass** das mindestens eine Schaltelement (9) im Antennenschalter (10) angeordnet ist.

3. Schaltungsanordnung gemäß einem der voranstehenden Patenansprüche 1 und 2,
**dadurch gekennzeichnet,**
**dass** der mindestens eine erste Empfänger (3.1) derart ausgeführt ist, dass dieser für den Empfang von Signalen aus dem UMTS-Netz geeignet ist.

4. Schaltungsanordnung gemäß einem der voranstehenden Patenansprüche 1 bis 3,
**dadurch gekennzeichnet**,
der mindestens eine zweite Empfänger (3.2) derart ausgeführt ist, dass dieser für den Empfang von Signalen aus dem GSM-Netz geeignet ist.

## Claims

1. Circuit arrangement for a multi-mode mobile telephone for transmitting/receiving signals into/from various mobile radio networks, comprising:
- a baseband (1) in which at least two analogue/digital converters (6.1 to 6.3) and one digital/analogue converter (7) are arranged, and
- a transmitting and receiving unit (2) in which at least one first receiver (3.1) and one second receiver (3.2) and at least one transmitter amplifier (4) are arranged, wherein the transmitter amplifier (4) and the second receiver (3.2) are designed for different modes of the multi-mode mobile telephone, wherein there are both connections (11.1, 11.2) between the outputs (17.1, 17.2) of the receivers (3.1, 3.2) and the analogue/digital converters (6.1, 6.2) and a connection (12) between the input (18) of the transmitter amplifier (4) and the digital/analogue converter (7), and connections (13.1, 13.2, 13.2' and 14) between the inputs (19.1, 19.2) of the first, the second receiver (3.1, 3.2), the output (20) of the transmitter amplifier (4) and an antenna switch (10), wherein the antenna switch (10) is connected to a transmitting and receiving antenna (8) and wherein the second receiver (3.2) is arranged for use as feedback branch as part of digital adaptive predistortion, and at least one switching element (9) is arranged between the output (20) of the at least one transmitter amplifier (4) and the input (19.2) of the second receiver (3.2) in such a manner that optionally either a connection (16') is created which connects the output (20) of the at least one transmitter amplifier (4) to the input (19.2) of the second receiver (3.2) or a connection is created which connects the input (19.2) of this second receiver (3.2) to the antenna switch (10).

2. Circuit arrangement according to the preceding Patent Claim 1, **characterized in that** the at least one switching element (9) is arranged in the antenna switch (10).

3. Circuit arrangement according to either of the preceding Patent Claims 1 and 2, **characterized in that** the at least one first receiver (3.1) is constructed in such a manner that it is suitable for the reception of signals from the UMTS network.

4. Circuit arrangement according to one of the preceding Patent Claims 1 to 3, **characterized in that** the at least one second receiver (3.2) is constructed in such a manner that it is suitable for the reception of signals from the GSM network.

## Revendications

1. Circuit pour un téléphone mobile multimodal pour l'émission / réception de signaux de / vers différents réseaux de radiocommunication mobile, comportant :
- une bande de base (1), dans laquelle au moins deux convertisseurs analogiques-numériques (6.1 à 6.3) et un convertisseur numérique-analogique (7) sont agencés, et
- une unité d'émission et de réception (2), dans laquelle au moins un premier récepteur (3.1) et un deuxième récepteur (3.2) et au moins un amplificateur d'émetteur (4) sont agencés, l'amplificateur d'émetteur (4) et le deuxième récepteur (3.2) étant conçus pour différents modes du téléphone mobile multimodal, des liaisons (11.1, 11.2) existant entre les sorties (17.1, 17.2) des récepteurs (3.1, 3.2) et les convertisseurs analogiques-numériques (6.1, 6.2), une liaison (12) existant entre l'entrée (18) de l'amplificateur d'émetteur (4) et le convertisseur numérique-analogique (7) et des liaisons (13.1, 13.2, 13.2' et 14) existant entre les entrées (19.1, 19.2) du premier et du deuxième récepteur (3.1, 3.2), la sortie (20) de l'amplificateur d'émetteur (4) et un commutateur d'antenne (10), le commutateur d'antenne (10) étant raccordé à une antenne d'émission et de réception (8) et le deuxième récepteur (3.2) étant conçu pour une utilisation comme branche de rétroaction dans le cadre d'une prédistorsion adaptative numérique et au moins un élément de commutation (9) étant agencé de telle sorte entre la sortie (20) du ou des amplificateurs d'émetteurs (4) et l'entrée (19.2) du deuxième récepteur (3.2) qu'il est créé sélectivement soit une liaison (16') qui relie la sortie (20) du ou des amplificateurs d'émetteurs (4) à l'entrée (19.2) du deuxième récepteur (3.2) soit une liaison qui relie l'entrée (19.2) du deuxième récepteur (3.2) au commutateur d'antenne (10).

2. Circuit selon la revendication précédente 1,
**caractérisé par le fait que** le ou les éléments de commutation (9) sont agencés dans le commutateur d'antenne (10).

3. Circuit selon l'une des revendications précédentes 1 et 2,
**caractérisé par le fait que** le ou les premiers récepteurs (3.1) sont réalisés de manière à convenir à la réception de signaux provenant du réseau UMTS.

4. Circuit selon l'une des revendications précédentes 1 à 3,
**caractérisé par le fait que** le ou les deuxièmes récepteurs (3.2) sont réalisés de manière à convenir à la réception de signaux provenant du réseau GSM.
